# EUROPEAN PATENT APPLICATION

(11) **EP 2 701 184 A1**
(43) Date of publication of application: **26.02.2014**
(21) Application number: 11861340.5
(22) Date of filing: 22.11.2011
(51) Int. Cl.: H01L 21/338, C23C 16/34, H01L 21/205, H01L 29/778, H01L 29/812

(54) **COMPOUND GaN SUBSTRATE AND METHOD FOR PRODUCING SAME, AND GROUP III NITRIDE SEMICONDUCTOR DEVICE AND METHOD FOR PRODUCING SAME**

(30) Priority: 22.03.2011 JP 2011062795
(71) Applicant: Sumitomo Electric Industries, Ltd., Osaka-shi, Osaka 541-0041 (JP)
(72) Inventor: KIYAMA, Makoto, Itami-shi Hyogo 664-0016 (JP); MATSUBARA, Hideki, Itami-shi Hyogo 664-0016 (JP); OKAHISA, Takuji, Itami-shi Hyogo 664-0016 (JP)
(74) Representative: Grünecker, Kinkeldey, Stockmair & Schwanhäusser
(86) International application number: PCT/JP2011/076887
(87) International publication number: WO 2012/127738

(57) **Abstract**

A composite GaN substrate (1) of the present invention includes: a conductive GaN substrate (10) having a specific resistance of less than 1 Ωcm; and a semi-insulative GaN layer (20) disposed on the conductive GaN substrate (10), having a specific resistance of 1 × 10⁴ Ωcm or more, and having a thickness of 5 µm or more. A group III nitride semiconductor device (2) of the present invention includes: the above-described composite GaN substrate (1); and at least one group III nitride semiconductor layer (30) disposed on the semi-insulative GaN layer (20) of the composite GaN substrate (1). In this way, there can be obtained the composite GaN substrate (1) and the semiconductor device (2) each having a high characteristic with reasonable cost.

## Description

### TECHNICAL FIELD

The present invention relates to a composite GaN substrate suitably used for a group III nitride semiconductor device, a method for manufacturing the composite GaN substrate, a group III nitride semiconductor device including the composite GaN substrate, and a method for manufacturing the group III nitride semiconductor device.

### BACKGROUND ART

In recent years, group III nitride semiconductor devices are widely applied not only to optical devices but also to electronic devices such as high electron mobility transistors (hereinafter, abbreviated as "HEMT").

For example, Yamada et al, "Effect of Epitaxial Layer Design on Drain Leakage Current for Millimeter-Wave GaN-HEMT", IEICE Technical Report, ED2009-48, The Institute of Electronics, Information and Communication Engineers, June 2009, pp63-67 (Non-Patent Literature 1) discloses a HEMT in which an i-GaN layer, an n-AlGaN layer, and an n-GaN layer are sequentially formed on a semi-insulative SiC substrate. Meanwhile, K. K. Chu et al, "9.4-W/mm Power Density AlGaN-GaN HEMTs on Free-Standing GaN Substrates", IEEE ELECTRON DEVICE LETTERS, Institute of Electrical and Electronic Engineers, VOL. 25, NO. 9, SEPTEMBER 2004, pp596-598 (Non-Patent Literature 2) discloses a HEMT in which a GaN layer and an AlGaN layer are sequentially formed on a semi-insulative, freestanding GaN substrate.

### CITATION LIST

### NON PATENT LITERATURE

NPL 1: Yamada et al., "Effect of Epitaxial Layer Design on Drain Leakage Current for Millimeter-Wave GaN-HEMT", IEICE Technical Report, ED2009-48, The Institute of Electronics, Information and Communication Engineers, June 2009, pp63-67
NPL 2: K. K. Chu et al, "9.4-W/mm Power Density AlGaN-GaN HEMTs on Free-Standing GaN Substrates", IEEE ELECTRON DEVICE LETTERS, Institute of Electrical and Electronic Engineers, VOL. 25, NO. 9, SEPTEMBER 2004, pp596-598

### SUMMARY OF INVENTION

### TECHNICAL PROBLEM

However, the HEMT disclosed in Yamada et al, "Effect of Epitaxial Layer Design on Drain Leakage Current for Millimeter-Wave GaN-HEMT", IEICE Technical Report, ED2009-48, The Institute of Electronics, Information and Communication Engineers. June 2009, pp63-67 (Non-Patent Literature 1), i.e., the HEMT including the GaN layer/AlGaN layer formed on the semi-insulative SiC substrate has a multiplicity of defects resulting from mismatching of crystal lattices between the SiC substrate and the GaN layer/AlGaN layer. Accordingly, deficiencies such as current drift are noticeable, disadvantageously.

On the other hand, the HEMT disclosed in K. K. Chu et al, "9.4-W/mm Power Density AlGaN-GaN HEMTs on Free-Standing GaN Substrates", IEEE ELECTRON DEVICE LETTERS, Institute of Electrical and Electronic Engineers, VOL. 25, NO. 9, SEPTEMBER 2004, pp596-598 (Non-Patent Literature 2), i.e., the HEMT including the GaN layer/AlGaN layer formed on the semi-insulative GaN substrate has little defects because matching of crystal lattices is excellent between the GaN substrate and the GaN layer/AlGaN layer. Accordingly, deficiencies such as current drift are little. However, because the semi-insulative GaN substrate is very expensive, the HEMT will be expensive, disadvantageously.

In view of this, the present invention has its object to provide a composite GaN substrate having a high characteristic with reasonable cost, a method for manufacturing such a composite GaN substrate, and a group III nitride semiconductor device, and a method for manufacturing the group III nitride semiconductor device.

### SOLUTION TO PROBLEM

According to a certain aspect, the present invention provides a composite GaN substrate including: a conductive GaN substrate having a specific resistance of less than 1 Ωcm; and a semi-insulative GaN layer disposed on the conductive GaN substrate, having a specific resistance of 1 × 10⁴ Ωcm or more, and having a thickness of 5 µm or more.

In the composite GaN substrate according to the present invention, the semi-insulative GaN layer can contain at least one kind of atoms selected from a group consisting of C, Fe, Cr, and V, as an impurity. Further, the semi-insulative GaN layer can contain C atoms as an impurity at a concentration of not less than 1 × 10¹⁷ cm⁻³ and not more than 5 × 10¹⁹ cm⁻³.

According to another aspect, the present invention provides a group III nitride semiconductor device including: the above-described composite GaN substrate; and at least one group III nitride semiconductor layer disposed on the semi-insulative GaN layer of the composite GaN substrate.

In the group III nitride semiconductor device according to the present invention, the group III nitride semiconductor layer can include an electron transit layer and an electron supply layer.

According to still another aspect, the present invention provides a method for manufacturing a composite GaN substrate, including the steps of: preparing a conductive GaN substrate having a specific resistance of less than 1 Ωcm; and growing a semi-insulative GaN layer on the conductive GaN substrate using an HVPE (hydride vapor phase epitaxy) method, the semi-insulative GaN layer having a specific resistance of 1 × 10⁴ Ωcm or more and having a thickness of 5 µm or more.

In the method for manufacturing the composite GaN substrate according to the present invention, the semi-insulative GaN layer can contain at least one kind of atoms selected from a group consisting of C, Fe, Cr, and V, as an impurity. Further, the semi-insulative GaN layer can contain C atoms as an impurity at a concentration of not less than 1 × 10¹⁷cm⁻³ and not more than 5 × 10¹⁹cm⁻³.

According to yet another aspect, the present invention provides a method for manufacturing a group III nitride semiconductor device, including the steps of: preparing the composite GaN substrate obtained through the above-described method for manufacturing the composite GaN substrate; and growing at least one group III nitride semiconductor layer on the semi-insulative GaN layer of the composite GaN substrate, using at least one of an MOVPE (metalorganic vapor phase epitaxy) method and an MBE (molecular beam epitaxy) method.

In the method for manufacturing the group III nitride semiconductor device according to the present invention, the group III nitride semiconductor layer can include an electron transit layer and an electron supply layer.

### ADVANTAGEOUS EFFECTS OF INVENTION

According to the present invention, there can be provided a composite GaN substrate having a high characteristic with reasonable cost, a method for manufacturing such a composite GaN substrate, a group III nitride semiconductor device, and a method for manufacturing the group III nitride semiconductor device.

### DESCRIPTION OF DRAWINGS

Fig. 1 is a schematic cross sectional view showing one exemplary composite GaN substrate according to the present invention.
Fig. 2 is a schematic cross sectional view showing one exemplary group III nitride semiconductor device according to the present invention.
Fig. 3 is a schematic cross sectional view showing an exemplary method for manufacturing each of the composite GaN substrate and the group III nitride semiconductor device in the present invention.
Fig. 4 is a schematic cross sectional view showing one exemplary, typical group III nitride semiconductor device.

### DESCRIPTION OF EMBODIMENTS

### [First Embodiment: Composite GaN Substrate]

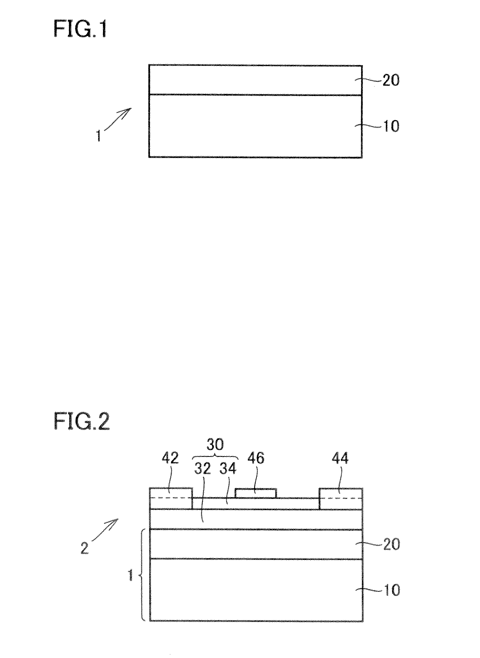

Referring to Fig. 1, a composite GaN substrate 1, which is one embodiment of the present invention, includes: a conductive GaN substrate 10 having a specific resistance of less than 1 Ωcm; and a semi-insulative GaN layer 20 disposed on conductive GaN substrate 10, having a specific resistance of 1 × 10⁴ Ωcm or more, and having a thickness of 5 µm or more. Because composite GaN substrate 1 of the present embodiment is thus configured to include conductive GaN substrate 10 and semi-insulative GaN layer 20, composite GaN substrate 1 can be a substrate with reasonable cost. Moreover, at least one group III nitride semiconductor layer having good crystal quality can be grown on semi-insulative GaN layer 20. Thus, a group III nitride semiconductor device having a high characteristic with reasonable cost can be suitably manufactured.

### (Conductive GaN Substrate)

Conductive GaN substrate 10 in composite GaN substrate 1 of the present embodiment is a single crystal having a specific resistance of less than 1 Ωcm. Here, the specific resistance of conductive GaN substrate 10 can be measured using a van der Pauw method or the like.

There is no particular limitation as to a method for obtaining such a conductive GaN substrate. In the case where a single-crystal substrate is employed therefor to obtain a substrate having good crystal quality, the following methods are suitable: vapor phase methods such as an HVPE (hydride vapor phase epitaxy) method, an MOVPE (metalorganic vapor phase epitaxy) method, and an MBE (molecular beam epitaxy) method; and liquid phase methods such as a flux method, and a high nitrogen pressure solution method.

Further, a donor impurity is generally added to conductive GaN substrate 10. For example, in order to reduce the specific resistance of conductive GaN substrate 10, conductive GaN substrate 10 can contain atoms such as O, Si, or Ge as the donor impurity.

### (Semi-Insulative GaN Layer)

In order to suitably form an electronic device such as a HEMT as a semiconductor device, semi-insulative GaN layer 20 in composite GaN substrate 1 of the present embodiment needs to have a specific resistance of 1 × 10⁴ Ωcm or more and have a thickness of 5 µm or more.

There is no particular limitation as to semi-insulative GaN layer 20 as long as semi-insulative GaN layer 20 has a specific resistance of 1 × 10⁴ Ωcm or more and has a thickness of 5 µm or more. However, in order to efficiently attain semi-insulation with the specific resistance of 1 × 10⁴ Ωcm or more, semi-insulative GaN layer 20 preferably contains atoms of an impurity such as C, Fe, Cr, V, Mg, or Zn. In order to stably attain the above-described semi-insulation, semi-insulative GaN layer 20 preferably contains at least one kind of atoms selected from a group consisting of C, Fe, Cr, and V, as the impurity. Further, in order to suppress the impurity in semi-insulative GaN layer 20 from being diffused into conductive GaN substrate 10 and a group III nitride semiconductor layer to be formed on semi-insulative GaN layer 20, semi-insulative GaN layer 20 more preferably contains C atoms as the impurity at a concentration of not less than 1 × 10¹⁷ cm⁻³ and not more than 5 × 10¹⁹ cm⁻³. When the concentration of the C atoms is less than 1 × 10¹⁷ cm⁻³, it is difficult to obtain semi-insulative GaN layer 20 having a high resistance, i.e., having a specific resistance of 1 × 10⁴ Ωcm or more. On the other hand, when the concentration of the C atoms is more than 5 × 10¹⁹ cm⁻³, the crystal quality of semi-insulative GaN layer 20 is decreased.

Further, there is no particular limitation as to a method for forming semi-insulative GaN layer 20 described above. However, in order to obtain a substrate having good crystal quality, the following methods are suitable: vapor phase methods such as the HVPE method, the MOVPE method, the MBE method, and a sublimation method; and liquid phase methods such as the flux method, and the high nitrogen pressure solution method. Of these methods, the HVPE method, which allows for high crystal quality and high crystal growth rate, is particularly suitable because it is advantageous to form a thick layer.

### [Second Embodiment: Group III Nitride Semiconductor Device]

Referring to Fig. 2, a group III nitride semiconductor device 2, which is another embodiment according to the present invention, includes: composite GaN substrate 1 of the first embodiment; at least one group III nitride semiconductor layer 30 disposed on semi-insulative GaN layer 20 of composite GaN substrate 1. In group III nitride semiconductor device 2 of the present embodiment, at least one group III nitride semiconductor layer 30 disposed on semi-insulative GaN layer 20 of composite GaN substrate 1 of the first embodiment has high crystal quality. Hence, group III nitride semiconductor device 2 has a high characteristic.

### (Composite GaN Substrate)

Composite GaN substrate 1 in group III nitride semiconductor device 2 of the present embodiment is the same as composite GaN substrate 1 of the first embodiment, and is not therefore described repeatedly here.

### (Group III Nitride Semiconductor Layer)

There is no particular limitation as to group III nitride semiconductor layer 30 in group III nitride semiconductor device 2 of the present embodiment. However, in order to form an electronic device such as a HEMT, group III nitride semiconductor layer 30 preferably includes an electron transit layer 32 and an electron supply layer 34. Further, there is no particular limitation as to electron transit layer 32 serving as group III nitride semiconductor layer 30. However, in order to improve electron mobility, electron transit layer 32 is preferably a GaN layer. Also, there is no particular limitation as to electron supply layer 34 serving as group III nitride semiconductor layer 30. However, in order to attain a high concentration of 2DEG (two dimensional electron gas), electron supply layer 34 is preferably an AlₓGa₁₋ₓN layer (0 < x < 1), an In_{y}Al_{1-y}N layer (0 < y < 0.3), or the like.

Further, there is no particular limitation as to a method for forming group III nitride semiconductor layer 30. However, in order to obtain a semiconductor layer having good crystal quality, the following methods are suitable: vapor phase methods such as the HVPE method, the MOVPE method, the MBE method, and the sublimation method; and liquid phase methods such as the flux method, and the high nitrogen pressure solution method. Of these methods, at least one of the MOVPE method and the MBE method is particularly suitable because these methods allow for a semiconductor layer having high crystal quality and are advantageous in adjusting the thickness of the semiconductor layer.

### (Electrodes)

Referring to Fig. 2, in addition to group III nitride semiconductor layer 30 including electron transit layer 32 and electron supply layer 34 described above, group III nitride semiconductor device 2 of the present embodiment includes the following electrodes: a source electrode 42 in contact with electron transit layer 32 and electron supply layer 34; a drain electrode 44 in contact with electron transit layer 32 and electron supply layer 34; and a gate electrode 46 in contact with electron supply layer 34. In this way, a HEMT can be configured.

Here, a material of each of source electrode 42 and drain electrode 44 is not particularly limited. An electrode formed of Ti layer/Al layer/Ti layer/Au layer is suitably used therefor. Also, a material of gate electrode 46 is not particularly limited. An electrode formed of Ni layer/Au layer is suitably used therefor.

### [Third Embodiment: Method for Manufacturing Composite GaN Substrate]

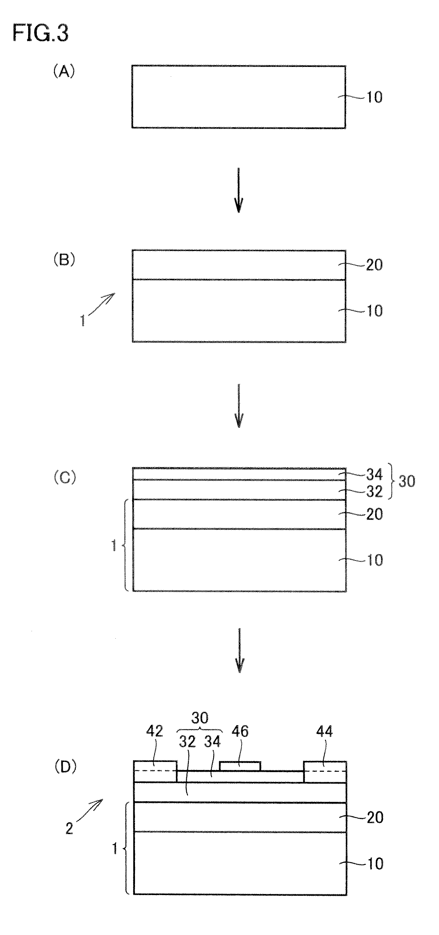

Referring to Fig. 3, a method for manufacturing composite GaN substrate 1, which is a still another embodiment according to the present invention, includes the steps of: preparing conductive GaN substrate 10 having a specific resistance of less than 1 Ωcm (Fig. 3(A)); and growing semi-insulative GaN layer 20 on conductive GaN substrate 10 using the HVPE method, semi-insulative GaN layer 20 having a specific resistance of 1 × 10⁴ Ωcm or more and having a thickness of 5 µm or more (Fig. 3(B)). According to the method for manufacturing the composite GaN substrate in the present embodiment, there can be efficiently manufactured composite GaN substrate 1 of the first embodiment by which a group III nitride semiconductor device having a high characteristic with reasonable cost can be suitably manufactured.

### (Step of Preparing Conductive GaN Substrate)

Referring to Fig. 3 (A), there is no particular limitation as to the step of preparing conductive GaN substrate 10 as long as conductive GaN substrate 10 having a specific resistance of less than 1 Ωcm can be prepared in the step. Hence, the step may be performed in any manner. For example, in the case of preparing a conductive GaN substrate of single crystal, in the case of a single crystal substrate, the following methods are suitable: vapor phase methods such as the HVPE method, the MOVPE method, the MBE method, and the sublimation method; and liquid phase methods such as the flux method, and the high nitrogen pressure solution method.

Further, conductive GaN substrate 10 can contain atoms such as, O, Si, or Ge as an impurity in order to reduce the specific resistance thereof.

### (Step of Growing Semi-Insulative GaN Layer)

Referring to Fig. 3(B), in order to form composite GaN substrate 1 suitable for manufacturing of a group III nitride semiconductor device, semi-insulative GaN layer 20 having a specific resistance of 1 × 10⁴ Ωcm or more and having a thickness of 5 µm or more is grown on conductive GaN substrate 10 using the HVPE method in the step of growing semi-insulative GaN layer 20. Because the HVPE method is employed as the growth method, a GaN layer having high crystal quality and having a large thickness can be efficiently grown. Further, by growing semi-insulative GaN layer 20 having a specific resistance of 1 × 10⁴ Ωcm or more and having a thickness of 5 µm or more, an electronic device such as a HEMT can be formed as the group III nitride semiconductor device so as to have a high-frequency characteristic substantially comparable to that in the case of employing a semi-insulating substrate.

Here, there is no particular limitation as to a manner of achieving the specific resistance of 1 × 10⁴ Ωcm or more in semi-insulative GaN layer 20 during the growth thereof. However, semi-insulative GaN layer 20 is preferably adapted to contain atoms such as C, Fe, Cr, V, Mg, or Zn as an impurity. In order to stably attain the above-described semi-insulation, semi-insulative GaN layer 20 preferably contains at least one kind of atoms selected from a group consisting of C, Fe, Cr, and V, as the impurity.

Further, in order to suppress the impurity in semi-insulative GaN layer 20 from being diffused into group III nitride semiconductor layer 30 to be formed on semi-insulative GaN layer 20, semi-insulative GaN layer 20 more preferably contains C atoms as the impurity at a concentration of not less than 1 × 10¹⁷ cm⁻³ and not more than 5 × 10¹⁹ cm⁻³. When the concentration of the C atoms is less than 1 × 10¹⁷ cm⁻³, it becomes difficult to obtain semi-insulative GaN layer 20 having a specific resistance of 1 × 10⁴ Ωcm or more. On the other hand, when the concentration of the C atoms is more than 5 × 10¹⁹ cm⁻³, the crystal quality of semi-insulative GaN layer 20 is decreased.

### [Fourth Embodiment: Method for Manufacturing Group III Nitride Semiconductor Device]

Referring to Fig. 3, a method for manufacturing group III nitride semiconductor device 2, which is yet another embodiment of the present invention, includes the steps of: preparing composite GaN substrate 1 of the first embodiment obtained using the method for manufacturing the composite GaN substrate in the third embodiment (Fig. 3(A) and Fig. 3(B)); and growing at least one group III nitride semiconductor layer 30 on semi-insulative GaN layer 20 of composite GaN substrate 1 using at least one of the MOVPE method and the MBE method (Fig. 3(C)). According to the method for manufacturing the group III nitride semiconductor device in the present embodiment, there can be suitably manufactured a group III nitride semiconductor device having a high characteristic with reasonable cost.

### (Step of Preparing Composite GaN Substrate)

Referring to Fig. 3(A) and Fig. 3(B), the step of preparing composite GaN substrate 1 of the first embodiment obtained through the method for manufacturing the composite GaN substrate in the third embodiment is the same as the method for manufacturing the composite GaN substrate as illustrated in the first and third embodiments, and is therefore not repeatedly described here.

### (Step of Growing Group III Nitride Semiconductor Layer)

Referring to Fig. 3(C), in the step of growing group III nitride semiconductor layer 30, at least one group III nitride semiconductor layer 30 is grown on semi-insulative GaN layer 20 of composite GaN substrate 1 using at least one of the MOVPE method and the MBE method.

Here, for the method for growing group III nitride semiconductor layer 30, at least one of the MOVPE method and the MBE method is employed because these methods allow for a semiconductor layer having high crystal quality and are advantageous in adjusting the thickness of the semiconductor layer.

Further, there is no particular limitation as to group III nitride semiconductor layer 30 to be grown. However, in order to form an electronic device such as a HEMT, group III nitride semiconductor layer 30 preferably includes electron transit layer 32 and electron supply layer 34. Further, there is no particular limitation as to electron transit layer 32. However, in order to improve electron mobility, electron transit layer 32 is preferably a GaN layer. Further, there is no particular limitation as to electron supply layer 34. However, in order to attain a high concentration of 2DEG (two dimensional electron gas), electron supply layer 34 is preferably an AlₓGa₁₋ₓN layer (0 < x < 1), an In_{y}Al_{1-y}N layer (0 < y < 0.3), or the like.

### (Step of Forming Electrodes)

Referring to Fig. 3(D), in addition to the step of growing group III nitride semiconductor layer 30 including electron transit layer 32 and electron supply layer 34 (Fig. 3(C)), the method for manufacturing group III nitride semiconductor device 2 of the present embodiment includes the step of forming the following electrodes: source electrode 42 in ohmic contact with electron transit layer 32 and electron supply layer 34; drain electrode 44 in ohmic contact with electron transit layer 32 and electron supply layer 34; and gate electrode 46 in Schottky contact with electron supply layer 34 (Fig. 3(D)). In this way, a HEMT can be configured.

Here, there is no particular limitation as to a method for forming each of source electrode 42 and drain electrode 44. For example, source electrode 42 and drain electrode 44 are formed on surfaces of parts of electron supply layer 34 by means of a lift-off method or the like employing photolithography and deposition. Then, heat treatment is performed to diffuse atoms in source electrode 42 and drain electrode 44 into the parts of electron supply layer 34. In this way, they are brought into ohmic contact with parts of electron supply layer 34 and electron transit layer 32.

Further, there is no particular limitation as to a method for forming gate electrode 46. For example, gate electrode 46 is formed on a surface of a part of electron supply layer 34 by means of the lift-off method or the like employing photolithography and deposition, so as to make Schottky contact with the part of electron supply layer 34.

### Examples

### [Example A: Composite GaN Substrate]

### 1. Preparation of Conductive GaN substrate

Referring to Fig. 3(A), as a base substrate, conductive GaN substrates 10 were prepared each of which had a specific resistance of 0.02 Ωcm, had an O atom concentration of 3 ×10¹⁸ cm⁻³, had a diameter of 2 inches (5.08 cm), had a thickness of 350 µm, had a main surface having a plane orientation of (000 1), and had a dislocation density of 1 × 10⁶ cm⁻². Each of conductive GaN substrates 10 was grown on a GaAs substrate using the HVPE method.

### 2. Growth of Semi-Insulative GaN Layer

Referring to Fig. 3(B), on the main surface of each conductive GaN substrate 10, a GaN layer was grown as semi-insulative GaN layer 20 using the HVPE method so as to have C atoms as its impurity and have a thickness of 10 µm. Six types of GaN layers (Example A-1 to Example A-6) having specific resistances different from one another were grown using a metal Ga as a Ga source material, using HCl gas and NH₃ gas as a source material gas, using H₂ gas as a carrier gas, and using CH₄ gas as a doping gas of C atoms. These GaN layers were grown under the following conditions: growth temperature was set at 1100°C; growth time was set at 10 min; HCl gas partial pressure was set at 3.2 × 10⁻² atm; NH₃ gas partial pressure was set at 0.04 atm; and CH₄ gas partial pressure was set at 5.0 × 10⁻⁵ atm (Example A-1), 1.0 × 10⁻⁴ atm (Example A-2), 1.0 × 10⁻³ atm (Example A-3), 1.0 × 10⁻² atm (Example A-4), 5.0 × 10⁻² atm (Example A-5), and 7.0 × 10⁻² atm (Example A-6).

The C atom concentration of each of the six types of GaN layers thus obtained was measured using a SIMS (secondary ion mass spectrometry) method. The specific resistance thereof was measured using a two-probe method. The crystal quality thereof was evaluated through X-ray diffraction. The surface state thereof was observed using a Nomarski interference microscope. Criteria for evaluation of the crystal quality were as follows: the crystal quality was regarded as "very good" when the half width of the peak of the diffraction intensity resulting from the (0002) plane of the GaN layer was 50 arcsec or less; the crystal quality was regarded as "good" when the half width was more than 50 arcsec and 200 arcsec or less; and the crystal quality was regarded as "bad" when the half width was more than 200 arcsec. Criteria for evaluation of the surface state were as follows: the surface state was regarded as "very good" when no macrostep and crack were generated in the surface; the surface state was regarded as "good" when macrostep was generated in the surface but no crack was generated therein; the surface state was regarded as "bad" when macrostep and crack were generated in the surface.

The GaN layer of Example A-1 had a C atom concentration of 5 × 10¹⁶ cm⁻³, had a specific resistance of 5 ×10⁻² Ωcm, and had very good crystal quality and surface state. The GaN layer of Example A-2 had a C atom concentration of 1 × 10¹⁷ cm⁻³, had a specific resistance of 1 × 10⁴ Ωcm, and had very good crystal quality and surface state. The GaN layer of Example A-3 had a C atom concentration of 1 × 10¹⁸ cm⁻³, had a specific resistance of more than 1 ×10⁷ Ωcm, and had very good crystal quality and surface state. The GaN layer of Example A-4 had a C atom concentration of 1 × 10¹⁹ cm⁻³, had a specific resistance of more than 1 × 10⁷ Ωcm, and had very good crystal quality and surface state. The GaN layer of Example A-5 had a C atom concentration of 5 × 10¹⁹ cm⁻³, had a specific resistance of more than 1 × 10⁷ Ωcm, and had good crystal quality and surface state. The GaN layer of Example A-6 had a C atom concentration of 7 × 10¹⁹ cm⁻³, had a specific resistance of more than 1 × 10⁷ Ωcm, and had bad crystal quality and surface state. These results are collectively shown in Table 1.

**[Table 1]**

| Example A | | Example A-1 | Example A-2 | Example A-3 | Example A-4 | Example A-5 | Example A-6 |
|---|---|---|---|---|---|---|---|
| CH₄ Gas Partial Pressure (atm) | | 5.0 × 10⁻⁵ | 1.0 × 10⁻⁴ | 1.0 × 10⁻³ | 1.0 × 10⁻² | 5.0 × 10⁻² | 7.0 × 10⁻² |
| GaN Layer | C Atom Concentration (cm⁻³) | 5.0 × 10¹⁶ | 1.0 ×10¹⁷ | 1.0 × 10¹⁸ | 1.0 × 10¹⁹ | 5.0 × 10¹⁹ | 7.0 × 10¹⁹ |
| | Specific Resistance (Ωcm) | 5.0 × 10⁻² | 1.0 × 10⁴ | >1.0 × 10⁷ | > 1.0 × 10⁷ | > 1.0 × 10⁷ | >1.0 × 10⁷ |
| | Crystal Quality | Very Good | Very Good | Very Good | Very Good | Good | Bad |
| | Surface State | Very Good | Very Good | Very Good | Very Good | Good | Bad |

Referring to Table 1, as the CH₄ gas partial pressure was increased during the growth of each GaN layer, the C atom concentration and specific resistance of the GaN layer were increased. When the CH₄ gas partial pressure was 1.0 × 10⁻⁴ atm or more, there were obtained the semi-insulative GaN layers each having a C atom concentration of 1 × 10¹⁷ cm⁻³ or more and having a specific resistance of 1 × 10⁴ Ωcm or more. When the CH₄ gas partial pressure became too high, the crystal quality and the surface state of the GaN layer were decreased. For example, when the CH₄ gas partial pressure was 5.0 × 10⁻² atm, the half width of the peak of the diffraction intensity in the X-ray diffraction became 100 arcsec, with the result that a multiplicity of macrosteps were generated in the surface. Further, when the CH₄ gas partial pressure was 7.0 × 10⁻² atm, the half width of the peak of the diffraction intensity in the X-ray diffraction became 1000 arcsec, with the result that a multiplicity of macrosteps and a multiplicity of cracks were generated in the surface.

### [Example B: Group III Nitride Semiconductor Device (HEMT)]

### 1. Preparation of Composite GaN Substrate

Referring to Fig. 3(A) and Fig. 3(B), conductive GaN substrates similar to those in Example A were prepared as base substrates. On the conductive GaN substrates thus prepared, semi-insulative GaN layers 20 having thicknesses different from one another were prepared under the same conditions as those of Example A-4 of Example A while changing the growth time thereamong, thereby preparing three types of composite GaN substrates 1 (Example B-1 to Example B-3). Here, semi-insulative GaN layers 20 respectively had thicknesses of 10 µm (Example B-1), 5 µm (Example B-2), and 2 µm (Example B-3).

In addition, a conductive GaN substrate 10 similar to that of Example A was prepared. A different type of composite GaN substrate 1 (Example B-4) was obtained by growing a semi-insulative GaN layer 20 on conductive GaN substrate 10 under the same conditions as those in Example A except that CpFe (ferrocene) was used instead of the CH₄ gas. Semi-insulative GaN layer 20 was grown to contain Fe at a concentration of 3 × 10¹⁹ cm⁻³, have a specific resistance of more than 1 × 10⁷ Ωcm, and have a thickness of 10 µm.

### 2. Growth of Group III Nitride Semiconductor Layer

Referring to Fig. 3(C), on each of the four types of semi-insulative GaN layers 20 of composite GaN substrates 1 in Example B-1 to Example B-4, a GaN layer serving as electron transit layer 32 and an Al_{0.2}Ga_{0.8}N layer serving as electron supply layer 34 were grown as at least one group III nitride semiconductor layer 30, using the MOVPE method.

Group III nitride semiconductor layer 30 was grown in the following procedure. First, the four types of semi-insulative GaN layer 20 of composite GaN substrate 1 in Example B-1 to Example B-4 were subjected to heat treatment in a reactor under an atmosphere of H₂ gas, N₂ gas, and NH₃ gas at a substrate temperature of 1100°C for 20 min. Next, the substrate temperature was set at 1130°C and NH₃ gas and TMG (trimethylgallium) were supplied to the reactor, so as to grow a GaN layer serving as electron transit layer 32 and having a thickness of 2.0 µm. Next, TMA (trimethylaluminum), TMG, and NH₃ gas were supplied to the reactor so as to grow an Al_{0.2}Ga_{0.8}N layer serving as electron supply layer 34 and having a thickness of 30 nm.

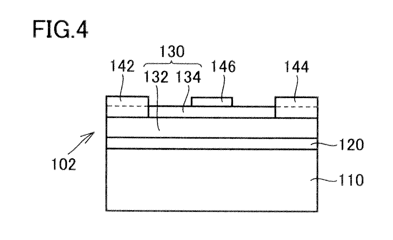

Further, referring to Fig. 4, as a reference example, Example B-5 was prepared as follows. That is, a semi-insulative SiC substrate 110 was prepared which had a specific resistance of 1 × 10⁷ Ωcm or more, had a diameter of 2 inches (5.08 cm), had a thickness of 400 µm, and had a main surface having a plane orientation of (0001). On semi-insulative SiC substrate 110 thus prepared, an AlN buffer layer 120 was formed using the MOVPE method at a growth temperature of 1150°C so as to have a thickness of 150 nm. On AlN buffer layer 120, a GaN layer serving as electron transit layer 132 and having a thickness of 2.0 µm and an Al_{0.2}Ga_{0.8}N layer serving as electron supply layer 134 and having a thickness of 30 nm were grown as group III nitride semiconductor layer 130 in the same manner as in each of Example B-1 to Example B-4.

The concentration (sheet carrier concentration) of 2DEG (two dimensional electron gas) formed in the vicinity of an interface between each of electron transit layers 32, 132 and each of electron supply layers 34, 134 thus obtained was measured through the following evaluation of C-V characteristics. Specifically, in such evaluation of C-V characteristics, sheet carrier concentration Ns of the 2DEG was calculated in the following manner. That is, on the surface of each of electron supply layers 34, 134 formed on electron transit layers 32, 132 formed on the substrates, a double-Schottky pattern having a diameter of 200 µm was formed from a Ni/Au electrode by means of the photolithography method. From C-V measurement thereof, the carrier concentration profile of the 2DEG layer was calculated and then integrated. The 2DEGs formed around the interfaces between electron transit layers 32, 132 and electron supply layers 34, 134 in Example B-1 to Example B-5 were respectively at sheet carrier concentrations Ns of 1.1 × 10¹³ cm⁻² (Example B-1), 1.1 × 10¹³ cm⁻² (Example B-2), 1.1 × 10¹³ cm⁻² (Example B-3), 0.9 × 10¹³ cm⁻² (Example B-4), and 1.0 × 10¹³ cm⁻² (Example B-5). The results are collectively shown in Table 2.

### 3. Formation of Electrodes

Referring to Fig. 3(D) and Fig. 4, in each of Example B-1 to Example B-5, parts of the Al_{0.2}Ga_{0.8}N layer serving as electron supply layer 34, 134 were subjected to photolithography and Ti layer/Al layer/Ti layer/Au layer were deposited using an electron beam. Then, using the lift-off method, source electrode 42, 142 and drain electrode 44, 144 were formed. Then, heat treatment was performed. The heat treatment was performed in a nitrogen atmosphere at 600°C for 30 seconds. Further, on a part of electron supply layer 34, 134, gate electrode 46, 146 was formed by means of the lift-off method so as to have a gate length of 0.5 µm and a gate width of 100 µm. Gate electrode 46, 146 is formed of an electrode with Ni layer/Au layer. In this way, five types of HEMTs were obtained as group III nitride semiconductor devices 2, 102 in Example B-1 to Example B-5. A cutoff frequency fT of each of the five types of HEMTs thus obtained was measured using a network analyzer. The HEMTs in Example B-1 to Example B-5 respectively have cutoff frequencies fT of 8 GHz (Example B-1), 6 GHz (Example B-2), 2 GHz (Example B-3), 6 GHz (Example B-4), and 10 GHz (Example B-5). The results are collectively shown in Table 2.

**[Table 2]**

| Example B | | | Example B-1 | Example B-2 | Example B-3 | Example B-4 | Example B-5 |
|---|---|---|---|---|---|---|---|
| Composite GaN Substrate | Type of Base Substrate | | Conductive GaN | Conductive GaN | Conductive CaN | Conductive GaN | Semi-Insulative SiC |
| | High-Resistance GaN Layer | Type of Impurity | C | C | C | Fe | - |
| | | Impurity Concentration (cm⁻³) | 1.0 × 10¹⁹ | 1.0 × 10¹⁹ | 1.0 × 10¹⁹ | 3.0 × 10¹⁹ | - |
| | | Thickness of GaN Layer (µm) | 10 | 5 | 2 | 10 | - |
| Semiconductor Device (HEMT) | | Sheet Carrier Concentration Ns (cm⁻²) | 1.1 × 10¹³ | 1.1 × 10¹³ | 1.1 × 10¹³ | 0.9 × 10¹³ | 1.0 × 10¹³ |
| | | Cutoff Frequency fT (GHz) | 8 | 6 | 2 | 6 | 10 |

Referring to Table 2, sheet carrier concentration Ns of the 2DEG in the electron transit layer and the electron supply layer formed on each of the semi-insulative GaN layers having C atoms added therein in Example B-1 to Example B-3 was 1.1 × 10¹³cm⁻², which was a high value. On the other hand, in Example B-4, sheet carrier concentration Ns of the 2DEG in the electron transit layer and the electron supply layer formed on the semi-insulative GaN layer having Fe atoms added therein was 0.9 × 10¹³ cm⁻², which was somewhat lower than that in each of Example B-1 to Example B-3. This is presumably because the Fe atoms added in the semi-insulative GaN layer are diffused into these layers during growth of the electron transit layer and the electron supply layer. Meanwhile, in Example B-5, sheet carrier concentration Ns of the 2DEG in the electron transit layer and the electron supply layer formed on the AlN buffer layer formed on the semi-insulative SiC substrate was 1.0 × 10¹³ cm⁻², which was somewhat lower than that in each of Example B-1 to Example B-3. This is presumably because dislocations formed in an interface between the semi-insulative SiC substrate and the AlN buffer layer and an interface between the AlN buffer layer and the electron transit layer result in carrier compensation.

Further, the HEMT (Example B-5) employing the typical semi-insulative SiC substrate had a cutoff frequency fT of 10 GHz. The HEMT (Example B-1) including the semi-insulative GaN layer having a thickness of 10 µm had a cutoff frequency fT of 8 GHz, i.e., had a high-frequency characteristic comparable to that of the HEMT employing the semi-insulative SiC substrate. The HEMT (Example B-2) including the semi-insulative GaN layer having a thickness of 5 µm had a cutoff frequency fT of 6 GHz, i.e., had a practically usable high-frequency characteristic. The HEMT (Example B-3) including the semi-insulative GaN layer having a thickness of 2 µm had a cutoff frequency fT of 2 GHz, i.e., had a high-frequency characteristic abruptly decreased therefrom. As such, it was found that a practically usable HEMT can be obtained by forming a semi-insulative GaN layer having a thickness of 5 µm or more on a conductive GaN substrate, and that a HEMT having a high-frequency characteristic comparable to or more excellent than the high-frequency characteristic of a HEMT employing a typical semi-insulating substrate can be obtained by forming a semi-insulative GaN layer having a thickness of 10 µm or more on a conductive GaN substrate.

Particularly, the semiconductor device (for example, the HEMT) of the invention of the present application is obtained by growing the group III nitride semiconductor layer on the composite GaN substrate including the conductive GaN substrate and the semi-insulative GaN layer, so that crystal lattice matching is very high between the composite GaN substrate and the group III nitride semiconductor layer. Thus, by using the composite GaN substrate having a low dislocation density, the dislocation density of the group III nitride semiconductor layer to be grown thereon becomes low. Hence, bad characteristics such as current drift, which cannot be improved by the typical semiconductor device (for example, the HEMT) employing the typical semi-insulative SiC substrate, can be improved.

The embodiments and examples disclosed herein are illustrative and non-restrictive in any respect. The scope of the present invention is defined by the terms of the claims, rather than the embodiments described above, and is intended to include any modifications within the scope and meaning equivalent to the terms of the claims.

### REFERENCE SIGNS LIST

1: composite GaN substrate; 2, 102: group III nitride semiconductor device; 10: conductive GaN substrate; 20: semi-insulative GaN layer; 30, 130: group III nitride semiconductor layer; 32, 132: electron transit layer; 34, 134: electron supply layer; 42, 142: source electrode; 44, 144: drain electrode; 46, 146: gate electrode; 110: semi-insulative SiC substrate; 120: AlN buffer layer.

## Claims

1. A composite GaN substrate comprising:
a conductive GaN substrate (10) having a specific resistance of less than 1 Ωcm; and
a semi-insulative GaN layer (20) disposed on said conductive GaN substrate, having a specific resistance of 1 × 10⁴ Ωcm or more, and having a thickness of 5 µm or more.

2. The composite GaN substrate according to claim 1, wherein said semi-insulative GaN layer (20) contains at least one kind of atoms selected from a group consisting of C, Fe, Cr, and V, as an impurity.

3. The composite GaN substrate according to claim 1, wherein said semi-insulative GaN layer (20) contains C atoms as an impurity at a concentration of not less than 1 × 10¹⁷ cm⁻³ and not more than 5 × 10¹⁹ cm⁻³.

4. A group III nitride semiconductor device comprising:
the composite GaN substrate (1) recited in claim 1; and
at least one group III nitride semiconductor layer (30) disposed on said semi-insulative GaN layer (20) of said composite GaN substrate (1).

5. The group III nitride semiconductor device according to claim 4, wherein said group III nitride semiconductor layer (30) includes an electron transit layer (32) and an electron supply layer (34).

6. A method for manufacturing a composite GaN substrate, comprising the steps of:
preparing a conductive GaN substrate (10) having a specific resistance of less than 1 Ωcm; and
growing a semi-insulative GaN layer (20) on said conductive GaN substrate using an HVPE method, said semi-insulative GaN layer (20) having a specific resistance of 1 × 10⁴ Ωcm or more and having a thickness of 5 µm or more.

7. The method for manufacturing the composite GaN substrate according to claim 6, wherein said semi-insulative GaN layer (20) contains at least one kind of atoms selected from a group consisting of C, Fe, Cr, and V, as an impurity.

8. The method for manufacturing the composite GaN substrate according to claim 6, wherein said semi-insulative GaN layer (20) contains C atoms as an impurity at a concentration of not less than 1 × 10¹⁷ cm⁻³ and not more than 5 × 10¹⁹ cm⁻³.

9. A method for manufacturing a group III nitride semiconductor device, comprising the steps of:
preparing the composite GaN substrate (1) obtained through the method for manufacturing the composite GaN substrate as recited in claim 6; and
growing at least one group III nitride semiconductor layer (30) on said semi-insulative GaN layer (20) of said composite GaN substrate (1), using at least one of an MOVPE method and an MBE method.

10. The method for manufacturing the group III nitride semiconductor device according to claim 9, wherein said group III nitride semiconductor layer (30) includes an electron transit layer (32) and an electron supply layer (34).
